# EUROPEAN PATENT APPLICATION

(11) **EP 3 267 211 A1**
(43) Date of publication of application: **10.01.2018**
(21) Application number: 16178072.1
(22) Date of filing: 06.07.2016
(51) Int. Cl.: G01R 31/12, G01R 31/16

(54) **A HIGH VOLTAGE UNIT FOR TESTING CAPABILITY OF A HIGH VOLTAGE COMPONENT TO WITHSTAND OPERATIONAL CONDITIONS**

(71) Applicant: NKT HV Cables GmbH, 5400 Baden (CH)
(72) Inventor: SVENSSON, Jerker, 44158 Alingsås (SE); HELLBLOM, Martin, 41459 Göteborg (SE); LICHY, Radim, 441 91 Alingsås (SE); DERAKHSHANFAR, Reza, 414 78 Göteborg (SE); SÖRQVIST, Torbjörn, 441 57 Alingsås (SE)
(74) Representative: Kransell & Wennborg KB

(57) **Abstract**

The invention relates to a high voltage unit (1; 10) for testing capability of a high voltage component (5) to withstand operational condition. The high voltage unit (1; 10) comprises: an insulation body (3; 30) comprising an electrically insulating material, the insulation body (3) at least partly covered by an outer conducting layer (2), wherein a first end (20) of the insulation body (3, 30) is arranged for receiving the high voltage component (5), and a second end (22) of the insulation body (3, 30) is arranged for subjecting the high voltage component (5) to the operational conditions, and electrical interconnection means (8a, 8b; 9) enabling an electrical interconnection between the high voltage component (5) when inserted at the first end (20) and a connector to a high voltage source when inserted at the second end (22).

## Description

### Technical field

The technology disclosed herein relates generally to the field of high voltage testing equipment, and in particular to a high voltage unit for testing capability of a high voltage component to withstand operational conditions and the use thereof in performing e.g. routine testing.

### Background

High voltage components have to be tested in different high voltage testing procedures in order to ensure that they are capable of withstanding high voltage stress during operation. Tests that are performed on completed equipment (as opposed to testing samples of e.g. dielectrics) comprise, for instance, measuring capacitance, power factor or total dielectric loss, partial discharges (PD), power frequency and transient impulse voltage withstand, breakdown voltage and flashover voltage.

Testing that is performed on high voltage equipment and components can be classified into different categories with respect to the test objective. These categories are normally referred to as development tests, design tests, type tests, sample tests, long-term tests, routine tests and tests after installation (or field tests). Development tests are usually not specified by standards. The other types of tests are commonly specified by national and international standards. Such standards exist for each type of equipment. An overall objective with all testing is to ensure proper product quality and long-term operation performance.

During the testing, a gas-filled container is often used in testing of the component. The gas is typically SF6, because of its high electronegativity. The SF6 absorbs free electrons produced during arcing and thus renders the testing safer. There are some risks involved when testing the equipment in such gas-filled environment. There is, for instance, a risk of leakage, and another drawback is that the gas pressure has to be supervised. Moreover, SF6 is a greenhouse gas and the use and handling must therefore be carefully considered.

Another known solution is to use a container filled with an insulating fluid when testing the component. This, however, requires large quantities of fluid and corresponding space. Further, the use of fluid such as oil also entails the risk of leakage, and many fluids are also non-environmentally friendly.

Another problem with known testing is that it is time consuming: the component needs to be set up, which may be cumbersome, and then a voltage is maintained over the component that is being tested, for instance, for 15 minutes up to 1,5 hours.

### Summary

An objective of the present disclosure is to address and improve various aspects for high-voltage testing procedures. A particular objective is to provide a high voltage unit that facilitates the testing and overcomes the above mentioned problems. Another particular objective is to shorten the time required for the testing. Still another particular objective is to provide a high-voltage unit usable also in permanent installations. These objectives and others are achieved by the high voltage unit and use thereof according to the appended independent claims, and by the embodiments according to the dependent claims.

The objective is according to an aspect achieved by a high voltage unit for testing capability of a high voltage component to withstand operational conditions. The high voltage unit comprises an insulation body comprising an electrically insulating material. The insulation body is at least partly covered by an outer conducting layer, wherein a first end of the insulation body is arranged for receiving the high voltage component, and a second end of the insulation body is arranged for subjecting the high voltage component to the operational conditions. The high voltage unit further comprises electrical interconnection means enabling an electrical interconnection between the high voltage component when inserted at the first end and a connector to a high voltage source when inserted at the second end.

The high voltage unit according to the invention provides many advantages. For instance, it is flexible in that it can be manufactured for different sizes and different types of components, and also for different voltage levels. The high voltage unit is easy to handle; it is, for instance, easy to insert e.g. an insulated electrode or cable termination and the component to be tested to the high voltage unit. This makes e.g. routine testing easy, time and cost efficient. The high voltage unit is also usable in more permanent uses, for instance used as a cable joint.

In a preferred embodiment, the insulation body comprises a solid insulation.

In an embodiment, the first end of the insulation body comprises a first insulation device arranged in the insulation body, and the second end of the insulation body comprises a second insulation device arranged in the insulation body.

In some embodiments, the first insulation device comprises a hollow body, the interior of which corresponds to the exterior shape of the test component.

In an embodiment, the first insulation device has a shape enabling reception of a test component being a stress relief cone.

In variations of the above embodiment, the first insulation device comprises a hollow body, the interior of which corresponds to the exterior shape of the stress relief cone.

The stress relief cone may be arranged, in a conventional manner, on a cable termination, which is then inserted into the first insulation device. By means of the invention, the stress relief cone may thereby be tested in a convenient manner.

In a variation of the above embodiment, the first insulation device and the second insulation device are arranged in a back-to-back connection.

In variations of the above two embodiments, the first insulation device and the second insulation device are arranged to receive a respective first and a second high voltage cable termination.

In some embodiments, the first insulation device is arranged to receive an electrode. The electrode may, for instance, comprise an insulated electrode, e.g. in the form of a dead-end terminated high voltage cable.

In other embodiments, the insulation body comprises, at the first end a first cavity formed for receiving the high voltage component, and the insulation body comprises, at the second end, a second cavity formed for receiving the connector to the high voltage source for subjecting the high voltage component to operational conditions. This is an even more cost-efficient solution, as the insulation devices of previous embodiments can be omitted.

In a variation of the above embodiments, the first cavity has a shape enabling reception of a test component being a stress relief cone. In other embodiments, the first cavity has a shape enabling reception of a test component being an insulator device. The high voltage unit may be designed in different ways depending on the test object at hand.

The objective is according to an aspect achieved by use of a high voltage unit as above, in testing high voltage components or equipment. The testing may, for instance, comprise one of: a routine test ensuring that the high voltage component is operational, and an out of circuit testing of an installed high voltage cable.

In an embodiment of the above use of the high voltage unit two or more high voltage components are tested simultaneously.

The use of the high voltage unit as a high voltage unit enables a faster and easier way of testing completed high voltage components and equipment compared to known testing methods.

Further features and advantages of the embodiments of the present teachings will become clear upon reading the following description and the accompanying drawings.

### Brief description of the drawings

Figure 1 illustrates a first embodiment of a high voltage unit according to the present invention.
Figure 2 illustrates a second embodiment of a high voltage unit according to the present invention.
Figure 3 illustrates a first use case for the high voltage unit according to the present invention.
Figure 4 illustrates a second use case for the high voltage unit according to the present invention.

### Detailed description

In the following description, for purposes of explanation and not limitation, specific details are set forth such as particular architectures, interfaces, techniques, etc. in order to provide a thorough understanding. In other instances, detailed descriptions of well-known devices, circuits, and methods are omitted so as not to obscure the description with unnecessary detail. Same reference numerals refer to same or similar elements throughout the description.

Briefly, the present invention comprises a high voltage unit 1, 10 that may be used for testing high voltage components. The high voltage unit 1, 10 may also be applied in more permanent uses, e.g. in cable joints. The high voltage unit 1, 10 comprises an insulation body 3, 30, an outer conducting layer 2 and electrical interconnection means 8a, 8b; 9.

The high voltage unit 1, 10 may, as mentioned, be used in performing routine tests and other tests of high voltage components, such as for instance high voltage field grading components, stress relief cones, joint adapters and also power cables. As another example, besides routine tests, the high voltage unit 1, 10 may be used for testing components after their installation at site. In the following the high voltage component 5 to be tested is also denoted test component 5. The high voltage unit 1, 10 is designed to accommodate the test component 5 within the insulation body 3, 30 or otherwise receive the test component 5.

As a particular example, the high voltage unit 1, 10 may be used for routine testing of stress relief cones for dry-type cable terminations for cable connections to gas-insulated metal-enclosed switchgear (GIS) and transformers. In use, such stress relief cone is arranged on the cable termination, which is then inserted into an insulator. The stress relief cone, when being tested in the high voltage unit 1, 10 according to the invention, is inserted into the insulation body 3, 30 of the high voltage unit 1, 10 and is hence tested in an environment in which is later is to be used (i.e. inside an insulator). The test environment is thus the same as the test component's (i.e. the stress relief cone) environment in use, which is in contrast to known routine test environments wherein the test components is surrounded by oil or gas. In some embodiments thus, a first insulation device 4a (described later) is the above described insulator.

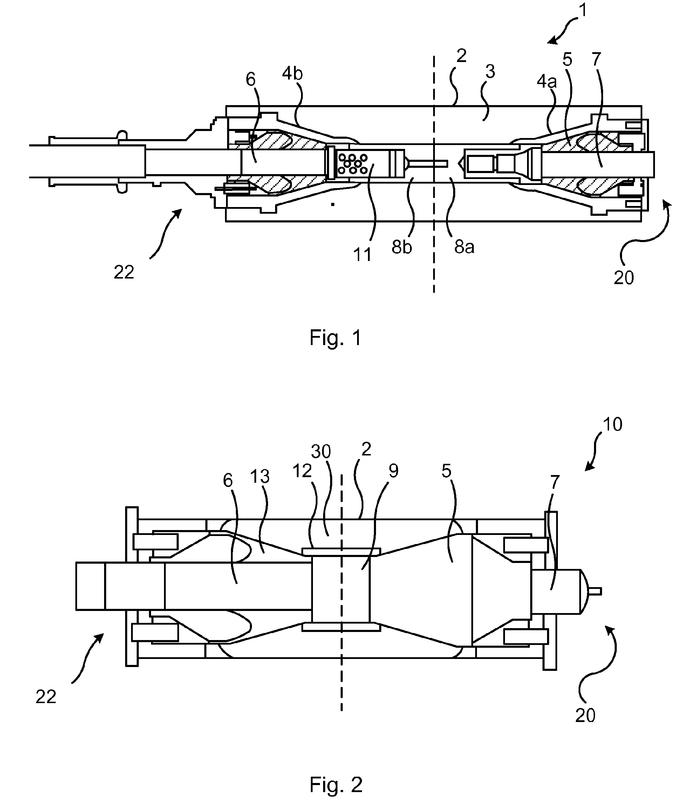

Figure 1 illustrates in a cross-sectional view a first embodiment of a high voltage unit 1 according to the present invention. The high voltage unit 1 comprises an insulation body 3, an outer conducting layer 2 and electrical interconnection means 8a, 8b.

The high voltage unit 1 comprises an insulation body 3 which comprises an insulating material, it may e.g. comprise rubber, gel, epoxy, cast resin or polyurethane or any combination thereof. The insulation body 3 may be made of, for instance, rubber, gel, epoxy, cast resin or polyurethane or any combination thereof. Depending on the choice of insulating material, the insulation body 3 may be molded, wounded, casted etc. The high voltage unit 1 may, for instance, have an essentially cylindrical outer shape.

The insulation body 3 has a first end 20 comprising a first opening for receiving a test component 5, and a second end 22 comprising a second opening arranged for subjecting the test component 5 for operational conditions. The test component 5 may be subjected to such operational conditions by interconnecting e.g. an insulated electrode inserted into the test component 5 to a high voltage source by means of a connector inserted at the second end 22. In this context, the insulated electrode is an electrically conducting body at a certain potential (in this case a high voltage). The connector may, for instance, comprise a cable termination. The insulation body 3 comprises a through-hole interconnecting the first and second openings of the respective first and second ends 20, 22.

The insulation body 3 is at least partly covered by an outer conducting layer 2, made of electrically conducting material. The insulation body 3 may be circumferentially surrounded or enclosed by the outer conducting layer 2. The outer conducting layer 2 encapsulates the electrical field created when e.g. performing a test on the test component, and the function of the outer conducting layer 2 may be compared to the electric field control function of an insulation screen of a high voltage cable. In a preferred embodiment, the outer conducting layer 2 is made of a conducting rubber, but it may be made of other conducting materials as well. The high voltage unit 1 is also designed to enable connection of the high voltage unit 1 to operational conditions in order to test the test component 5 under real working conditions. In figure 1, at a second end 22 of the high voltage unit 1, the high voltage unit 1 is arranged to be connected to, for instance, a high voltage source, a switchgear or an overhead line (not shown). The second end 22 may, for instance, be arranged to receive a cable termination, wherein the cable of the cable termination is connected to a high voltage source.

In the embodiment illustrated in figure 1, the high voltage unit 1 comprises two insulation devices 4a, 4b arranged at the opposite ends of the insulation body 3. At the first end 20 of the high voltage unit 1, a first insulation device 4a is arranged within the insulation body 3. In particular, the opening of the first end 20 of the insulation body 3 accommodates the first insulation device 4a. Correspondingly, at the second end 22 of the high voltage unit 1, a second insulation device 4b is arranged within the insulation body 3. In particular, the opening of the second end 22 of the insulation body 3 accommodates the second insulation device 4b. The insulation devices 4a, 4b are, in this embodiment, integrated parts of the high voltage unit 1. If, for instance, manufacturing the high voltage unit 1 by molding the insulation body, the first and second insulation devices 4a, 4b may be integrated in the insulation body during the molding process.

The insulation devices 4a, 4b may, for instance, be made of an electrically insulating material such as epoxy. It is noted that the degree of electrical insulation capability of an electrically insulating material may be selected based on particular requirements at hand, e.g. depending on what type of testing is to be performed.

The first insulation device 4a at the first end 20 of the high voltage unit 1 has a shape such as to receive a test component 5. For instance, for a rod-shaped test component, the first insulation device 4a may comprise a corresponding rod-shaped hole for receiving the rod-shaped test component. For the earlier described example of the test component 5 being a stress relief cone, the first insulation device 4a has an inner shape corresponding to the exterior shape of the stress relief cone. That is, the first insulation device 4a comprises a cavity shaped to receive the stress relief cone. When the stress relief cone is inserted into the first insulation device 4a there should be no space between the interior of the first insulation device 4a and the exterior of the stress relief cone, i.e. in use there is a tight fit between the first insulation device 4a and the stress relief cone.

It is noted that the insulation body 3 does not need to be symmetrical in the longitudinal direction (horizontal direction in the figure), i.e. the first and second ends 20, 22 may be differently shaped for accommodating e.g. differently sized insulation devices 4a, 4b. For instance, the opening at the first end 20 may be differently shaped than the opening at the second end 22, and the insulation devices 4a, 4b may correspondingly have different shapes.

The insulation devices 4a, 4b may, as illustrated, be arranged in a back-to-back connection. Each insulation device 4a, 4b may have attached thereto or comprise an electrically conducting part 8a, 8b, which parts 8a, 8b are electrically interconnected and thereby mechanically and electrically connects the insulation devices 4a, 4b together. As a particular example, the insulator devices 4a, 4b may have attached thereto a top fitting within which a plug-in connector may be arranged. That is, in some embodiments, the insulation devices 4a, 4b comprises a respective conductive part, which parts are arranged for enabling swift interconnection, for instance, by a plug-in type of connection. The first and second electrically conducting part 8a, 8b may thus be designed such as to be easily attached to e.g. a high voltage cable termination. The first and second electrically conducting part 8a, 8b may, for instance, comprise attachment means for receiving a plug-in connector 11. The first electrically conducting part 8a is fastened to the first insulation device 4a and the second electrically conducting part 8b is fastened to the second insulation device 4b. Further, the first and second electrically conducting parts 8a, 8b are interconnected to each other, for instance by a screw connection.

In some embodiments, the conducting parts 8a, 8b may be (pre-)arranged in the through-hole of the insulation body 3. In figure 1, at a first end 20 of the high voltage unit 1, the high voltage unit 1 is arranged to receive a test component 5 to be tested (or to be mounted for more permanent use). In the embodiment illustrated in figure 1, the test component 5 is a stress relief cone and its endurance to the operational conditions has to be tested before it can be delivered to a customer and subsequently be used.

In figure 1, the test component 5 is a premolded stress relief cone shown inserted at the first end 20 end of the insulation body 3 (the first opening thereof), in particular inserted in the first insulation device 4a. At use, a high voltage cable 6 connected to a high voltage source may be inserted in the second end 22 of the insulation body 3 for testing the test component 5, in this case the stress relief cone. The high voltage cable 6, and in particular a cable termination thereof, may, as illustrated, be a conventional cable termination comprising e.g. a stress relief cone and other known cable termination accessories.

In use e.g. in a routine test, an insulated electrode 7 and stress relief cone 5 may, as mentioned earlier, be inserted in the first end 20 of the insulation body 3, in particular inserted into the first insulation device 4a. The insulated electrode 7 is shown schematically in the figure, and comprises an electrically conducting element, made e.g. of a metal, and an insulation surrounding the electrically conducting element. The insulated electrode 7 is, in use, interconnected with the high voltage source via the second end 22 of the high voltage unit 1. The insulated electrode 7 may be seen as a blind-end electrode.

Figure 2 illustrates a second embodiment of a high voltage unit 10 according to the present invention. In essence, this embodiment omits the first and second insulation devices 4a, 4b that are included in the embodiments described with reference to figure 1, thereby rendering the high voltage unit 10 more cost efficient and easier to produce. The high voltage unit 10 according to this embodiment is also easier to use and has smaller dimensions, making it easier to handle. The high voltage unit 10 illustrated in figure 2 is hence similar to the high voltage unit 1 illustrated in figure 1. The high voltage unit 10 comprises the insulation body 30 surrounded by, or at least partly covered by, the conducting outer layer 2, as the embodiments described with reference figure 1. The description given in relation to figure 1 is not repeated here, but may be referred to for further details on e.g. material of the insulation body 30 or for details on the conducting outer layer 2.

Also in line with the embodiments described with reference to figure 1, the high voltage unit 10 is designed to accommodate within an insulation body 30 or otherwise receive the high voltage component that is to be tested. In figure 2, the high voltage unit 10 is, at a first end 20 thereof, arranged to receive the test component 5.

The high voltage unit 10 is also designed to enable connection of the high voltage unit 10 to operational conditions in order to test the test component 5 under real working conditions. In figure 2, at a second end 22 of the high voltage unit 10, the high voltage unit 10 is arranged to be connected to, for instance, a switchgear or overhead bus bar by termination (not shown). As described for the previous embodiments, the second end 22 may, for instance, be arranged to receive a cable termination, wherein the cable of the cable termination is connected to a high voltage source.

The insulation body 30 in the high voltage unit 10 according to this embodiment comprises a body comprising electrically insulating material, e.g. rubber, i.e. the solid insulation may comprise a rubber body.

The electrical interconnection means enabling an electrical interconnection between the first end 20 and the second end 22 is in this embodiment a contact device 9 of electrically conducting material, e.g. metal arranged in a through-hole of the insulation body 3. The through-hole interconnects the openings of the first and second ends 20, 22. The contact device 9 enables electrical contact between, for instance, a first high voltage cable 6 (connected to a high voltage source) inserted in the second end 22 and a second high voltage cable or, as shown in figure 2, an electrode 7 inserted into the test component 5 in the first end 20. The insulation body 30 comprises an inner conducting deflector 12 arranged within the solid insulation, in particular in connection to the contact device 9, e.g. arranged circumferentially around the contact device 9.

The insulation body 30 is formed at the first end 20 of the high voltage unit 10 such as to accomplish the reception of the test component 5, and also formed at the second end 22 of the insulation body 30 such as to accomplish the reception of the means for connecting the high voltage unit 10 to operational conditions. The insulation body 30 may, for instance, be molded to have the desired shape, enabling the reception as described. The reception means in the first end 20 may comprise a first cavity formed in the insulation body 30 at the first end 20 for receiving the tested component 5. The reception means in the second end 22 comprises a cavity formed in the insulation body 30 at the second end 22 for subjecting the high voltage component 5 to operational conditions, by e.g. receiving a high voltage cable termination connected to an overhead line. The through-hole mentioned earlier, interconnects these cavities.

As a particular example, the test component 5 may be an insulator to be used for a cable termination. In this context an entire cable termination may then be the insulator together with a stress relief cone assembly, wherein the stress relief cone assembly (or parts thereof) is to be inserted into the insulator. It is noted that this is given purely as an example, and that the first and second ends 20, 22 may be formed to suit a test component 5 of any shape.

It may also be noted that the high voltage unit 1, 10 that has been described in various embodiments, may be provided with e.g. a metallic housing and other outer protection means. Such further protection means may, for instance, be necessary for safety reasons when using the high voltage unit 1, 10 in field.

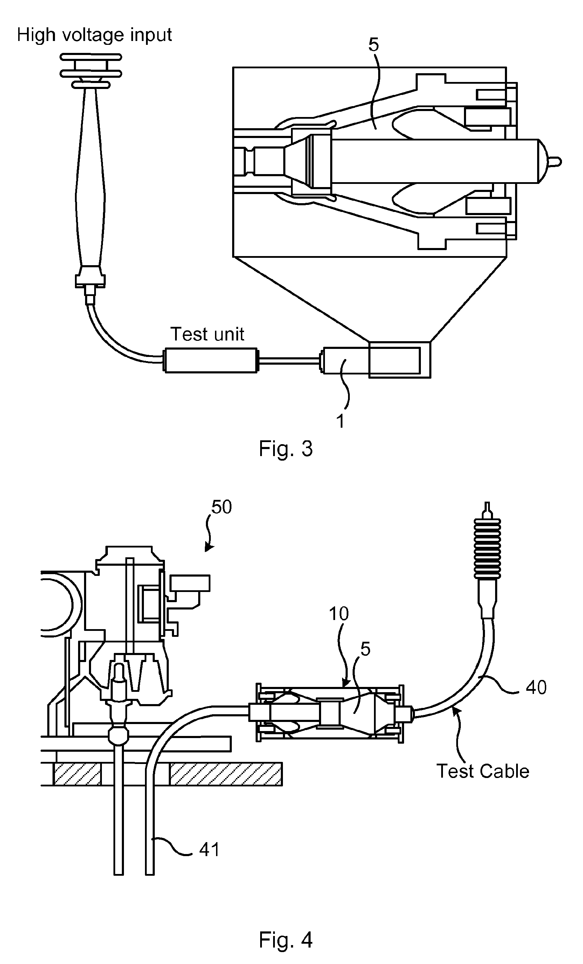

Figure 3 illustrates a first use case for the high voltage unit 1, 10 according to the present invention. A test component 5, once again exemplified by a stress relief cone, is connected by means of a high voltage cable such as to subject the test component 5 to operational conditions. In the figure this is exemplified by a high voltage cable connected to a high voltage source. As also shown, several high voltage units (two illustrated) may be interconnected, hence enabling several components to be tested simultaneously. This shortens the time required for routine tests.

Figure 4 illustrates a second use case for the high voltage unit 1, 10 according to the present invention. In the illustrated use case, the tested component is a high voltage cable 41. The cable that is currently connected to a gas insulated switchgear 50 is removed and the high voltage cable 41 to be tested is instead connected to the high voltage unit 10. The tested high voltage cable is inserted into the high voltage unit 10 at the second end 22 thereof. At the first end 20 of the high voltage unit 10 a test cable 40 is inserted in order to energize with test voltage and collect data ensuring that the power cable under test is functioning properly when installed, i.e. when connected to the gas insulated switchgear 50. The high voltage unit 10 can be made smaller and weigh less than conventional test units, and can be used as a test unit that can be brought along e.g. by maintenance personal.

The high voltage unit 1, 10 that has been described in many different embodiments may be used for performing routine tests of the kind described in the background section. In contrast to known devices wherein oil or gas such as SF6 is used as insulation when performing the tests, the high voltage unit 1, 10 according to the invention comprises a solid insulation. This feature overcomes problems and disadvantages of the prior art e.g. by eliminating risk of leakage of gas or oil, and also eliminating need for supervision of e.g. gas pressure. The high voltage unit 1 is thus a more cost-efficient solution. The high voltage unit 1, 10 further ensures that the test component possesses the required capabilities by being tested in a real working environment.

The high voltage unit 1, 10 when used in e.g. routine testing, provides also advantages such as reducing the time required for performing the test. The high voltage unit 1, 10 enables several test components 5 to be tested simultaneously, and large time savings are thereby enabled, particular in view of some routine tests requiring an hour per tested component.

The use of the high voltage unit 1, 10 can be automatized, e.g. by mounting the high voltage unit 1, 10 in a mechanical construction and using e.g. robot technology for automatically placing the test component 5 in the first end 20 of the high voltage unit 1, 10 and automatically connecting to each insulation device 4a, 4b of the first and second ends 20, 22 of the high voltage unit 1, 10, e.g. a respective high voltage cable termination. This speeds up a testing procedure considerably, while also ensuring that each testing is always performed in the same way. Further, several components can be tested simultaneously also in such use. The use of the high voltage unit 1, 10 can alternatively be semi-automatized, wherein some elements are performed manually. The high voltage unit 1, 0 and use thereof have many further advantages. For instance, it is flexible for different sizes and different types of components, and also for different voltage levels. The high voltage unit 1 is easy to handle; it is, for instance, easy to connect e.g. an electrode or cable terminations and the components to be tested to the high voltage unit 1, 10. This makes e.g. routine testing easy even without automation, and is thereby time and cost efficient.

The invention has mainly been described herein with reference to a few embodiments. However, as is appreciated by a person skilled in the art, other embodiments than the particular ones disclosed herein are equally possible within the scope of the invention, as defined by the appended patent claims.

## Claims

1. A high voltage unit (1; 10) for testing capability of a high voltage component (5) to withstand operational condition, the high voltage unit (1; 10) comprising:
- an insulation body (3; 30) comprising an electrically insulating material, the insulation body (3; 30) at least partly covered by an outer conducting layer (2), wherein a first end (20) of the insulation body (3, 30) is arranged for receiving the high voltage component (5), and a second end (22) of the insulation body (3, 30) is arranged for subjecting the high voltage component (5) to the operational conditions, and
- electrical interconnection means (8a, 8b; 9) enabling an electrical interconnection between the high voltage component (5) when inserted at the first end (20) and a connector to a high voltage source when inserted at the second end (22).

2. The high voltage unit (1; 10) as claimed in claim 1, wherein the insulation body (3, 30) comprises a solid insulation.

3. The high voltage unit (1) as claimed in claim 1 or 2, wherein:
- the first end (20) of the insulation body (3) comprises a first insulation device (4a) arranged in the insulation body (3), and
- the second end (22) of the insulation body (3) comprises a second insulation device (4b) arranged in the insulation body (3).

4. The high voltage unit (1; 10) as claimed in claim 3, wherein the first insulation device (4a) comprises a hollow body, the interior of which corresponds to the exterior shape of the test component (5).

5. The high voltage unit (1; 10) as claimed in claim 3 or 4, wherein the first insulation device (4a) has a shape enabling reception of a test component (5) being a stress relief cone.

6. The high voltage unit (1; 10) as claimed in claim 5, wherein the first insulation device (4a) comprises a hollow body, the interior of which corresponds to the exterior shape of the stress relief cone.

7. The high voltage unit (1) as claimed in any of claims 3-6, wherein the first insulation device (4a) and the second insulation device (4b) are arranged to receive a first and second high voltage cable termination, respectively.

8. The high voltage unit (10) as claimed in claim 1 or 2, wherein the insulation body (30) comprises:
- at the first end (20), a first cavity formed for receiving the high voltage component (5), and
- at the second end (22), a second cavity formed for receiving the connector to the high voltage source for subjecting the high voltage component (5) to operational conditions.

9. The high voltage unit (10) as claimed in claim 8, wherein the first cavity has a shape enabling reception of a test component (5) being a stress relief cone.

10. The high voltage unit (10) as claimed in claim 8, wherein the first cavity has a shape enabling reception of a test component (5) being an insulator device.

11. Use of high voltage unit (1, 10) as claimed in any of the preceding claims, in testing high voltage component (5), the testing comprising one of: a routine test ensuring that the high voltage component (5) is operational, and an out of circuit testing of an installed high voltage cable.

12. The use of the high voltage unit (1, 0) as claimed in claim 11, comprising testing simultaneously two or more high voltage components (5).
